# EUROPEAN PATENT APPLICATION

(11) **EP 4 756 698 A1**
(43) Date of publication of application: **10.06.2026**
(21) Application number: 23947555.1
(22) Date of filing: 31.07.2023
(51) Int. Cl.: G06Q 50/04, G06F 30/13, G06F 30/27

(54) **SUPPORT METHOD, SUPPORT DEVICE, SUPPORT PROGRAM, AND METHOD FOR CONSTRUCTING DEVELOPMENT SUPPORT SYSTEM**

(71) Applicant: Chiyoda Corporation, Kanagawa 220-8765 (JP)
(72) Inventor: YAMAGUCHI, Yoshihiro, Yokohama-shi, Kanagawa 220-8765 (JP); MIZUTANI, Takato, Yokohama-shi, Kanagawa 220-8765 (JP); NOMURA, Yoshinari, Yokohama-shi, Kanagawa 220-8765 (JP); FURUICHI, Kazuya, Yokohama-shi, Kanagawa 220-8765 (JP)
(74) Representative: Gulde & Partner
(86) International application number: PCT/JP2023/027981
(87) International publication number: WO 2025/027756

(57) **Abstract**

A method for supporting development of a model related to operation of a plant facility is executed by a processor and includes: acquiring facility identification information of the plant facility or process identification information of a process executed in the plant facility; acquiring target output information of the model; and outputting a processing element list including a processing element that is to constitute a development process of the model, based on the facility identification information or the process identification information and the target output information.

## Description

### Technical Field

The present invention relates to a method for supporting development of a model related to operation of a plant facility, a support device, a support program, and a method for constructing a development support system.

### Background Art

Various models are used to design, construct, operate, and manage a plant. A model tailored to the type, scale, location, etc., of the plant is developed for each plant.

### Citation List

### Patent Literature

[Patent Literature 1] Japanese Unexamined Patent Application Publication No. 2023-016369

### Summary of Invention

### Technical Problem

While being involved in the design, construction, operation, management, etc., of many plants, the inventors of the present invention recognized that even if the type, scale, location, etc., of the plants are different, there are many common parts in the work processes for developing a model and in the processing elements such as algorithms that constitute the model. Then, they have conceived a technology that makes it possible to reduce the cost, time, labor, etc., required for the development of a new model by actively utilizing the knowledge and resources from when a model was developed in the past.

The present invention has been made in view of such circumstances, and an object thereof is to provide a technology for supporting the development of a model related to the operation of a plant facility.

### Solution to Problem

To solve the above problem, a method according to an aspect of the present disclosure is a method for supporting development of a model related to operation of a plant facility, wherein the method is executed by a processor and includes: acquiring facility identification information of the plant facility or process identification information of a process executed in the plant facility; acquiring target output information of the model; and outputting a processing element list including a processing element that is to constitute a development process of the model, based on the facility identification information or the process identification information and the target output information.

Another aspect of the present disclosure is a support device. This device comprises: an information acquisition unit that acquires facility identification information of a plant facility or process identification information of a process executed in the plant facility, and target output information of a model related to operation of the plant facility; and an output unit that outputs a processing element list including a processing element that is to constitute a development process of the model, based on the facility identification information or the process identification information and the target output information acquired by the information acquisition unit.

Still another aspect of the present disclosure is a method for constructing a development support system. This method is a method for constructing a development support system for a second model related to operation of a plant facility, wherein the method is executed by a processor and includes: acquiring facility identification information of the plant facility or process identification information of a process executed in the plant facility, which is a target of a developed first model, and target output information of the first model; acquiring a processing element that constitutes a development process of the developed first model; and storing the processing element in association with the facility identification information or the process identification information, and/or the target output information.

Still another aspect of the present invention is a support device. This device is a support device for constructing a development support system for a second model related to operation of a plant facility, the device comprising: an information acquisition unit that acquires facility identification information of the plant facility or process identification information of a process executed in the plant facility, which is a target of a developed first model, and target output information of the first model; a processing element acquisition unit that acquires a processing element that constitutes a development process of the developed first model; and a storage unit that stores the processing element in association with the facility identification information or the process identification information, and/or the target output information.

It should be noted that any combination of the above-described constituent elements and any conversion of the expression of the present invention among a method, a device, a system, a recording medium, a computer program, and the like are also effective as aspects of the present invention.

According to the present invention, it is possible to provide a technology for supporting the development of a model related to the operation of a plant facility.

### Brief Description of Drawings

FIG. 1 is a diagram schematically illustrating an example of a method for developing a model related to operation of a plant facility.
FIG. 2 is a diagram illustrating a configuration of a development support system according to an embodiment.
FIG. 3 is a diagram illustrating a configuration of a construction support device according to the embodiment.
FIG. 4 is a flowchart illustrating a procedure of a support method according to the embodiment.
FIG. 5 is a diagram illustrating an example of a data structure of a processing element holding unit.
FIG. 6 is a diagram illustrating an example of a data structure of the processing element holding unit.
FIG. 7 is a diagram illustrating a configuration of a development support device according to the embodiment.
FIG. 8 is a flowchart illustrating a procedure of a support method according to the embodiment.
FIG. 9 is a diagram illustrating an example of a screen displayed on a display device of the development support device.
FIG. 10 is a diagram illustrating an example of a screen displayed on the display device of the development support device.

### Description of Embodiments

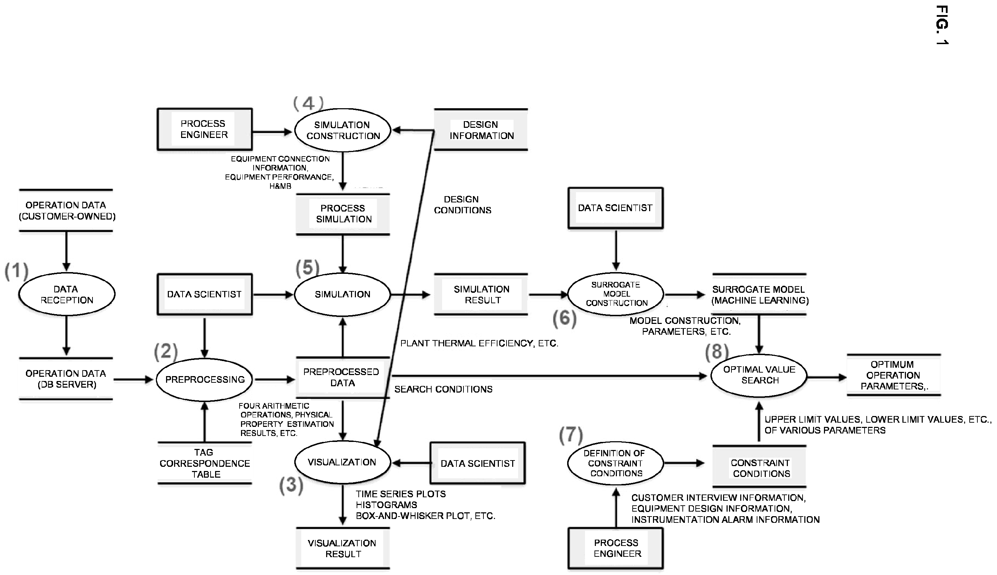

FIG. 1 schematically illustrates an example of a method for developing a model related to the operation of a plant facility. This figure illustrates a procedure of a method for developing an AI (Artificial Intelligence) that optimizes the operation of the plant facility, as an example of a model related to the operation of the plant facility.

In step (1), operation data collected and accumulated in an existing plant facility owned by a customer is stored in a database server.

In step (2), preprocessing is executed on the operation data stored in the database server. The preprocessing may include, for example, a process of assigning the same tag to operation data when different tags are assigned to the same or similar operation data, unifying units of the operation data, adjusting an offset of the operation data, processing an outlier of the operation data, normalizing the operation data, complementing missing operation data, or calculating other data representing a physical property, a state, or the like from the operation data using a predetermined calculation formula, algorithm, simulation, or the like. The preprocessing may be executed with reference to a tag correspondence table that defines a correspondence relationship of tags assigned to the operation data. The content of the preprocessing may be determined by a data scientist having specialized knowledge for organizing and analyzing data.

In step (3), the data scientist visualizes the preprocessed data with reference to design information such as a process flow diagram (PFD) and a heat and material balance (H&MB). The data scientist visualizes the preprocessed data in a manner that matches the design information of the plant, such as a time-series plot, a histogram, or a box-and-whisker plot. The visualized data may be referred to by the data scientist or a process engineer in subsequent steps, or may be provided to the customer. The visualized data can be used, for example, for grasping an operation state of the plant (a production amount of a product, presence/absence of an operation stop, efficiency of a device, etc.), for selecting the operation data (a data type, an extraction period), and for confirming the validity of the preprocessing of the operation data.

In step (4), the process engineer, who has specialized knowledge regarding the design and operation of the plant facility, constructs a process simulation for simulating the operation of the plant facility based on design information such as the process flow diagram (PFD), the heat and material balance (H&MB), and device performance. When an existing process simulator exists, this step (4) is omitted. 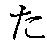

In step (5), the data scientist simulates the operation of the plant facility by using the preprocessed data of a stable region as an input value for the process simulation, and obtains a simulation result such as a thermal efficiency of the plant.

In step (6), the data scientist constructs a surrogate model that substitutes for the process simulation. The surrogate model inputs the preprocessed data of the stable region and outputs the simulation result without simulating the operation of the plant facility. The surrogate model may be constructed by a neural network or the like. The data scientist trains the surrogate model using the preprocessed data and the simulation result from the process simulation as training data. For example, an intermediate layer of the neural network may be adjusted such that when the preprocessed data is input to an input layer of the neural network, actual data corresponding to the preprocessed data, or a simulation result output when the preprocessed data is input to the process simulation, is output from an output layer of the neural network. Note that for the surrogate model, an emulation model constructed based on operation data or a physical model constructed based on a first-principles rule may be utilized.

In step (7), the process engineer defines constraint conditions for optimizing the operation of the plant facility. The constraint conditions may be upper limit values, lower limit values, etc., of various parameters. The process engineer may define the constraint conditions based on information obtained by interviewing the customer, device design information, instrumentation alarm information, and the like.

In step (8), an operation optimization AI searches for a value of an operation parameter that optimizes the operation of the plant facility under the defined constraint conditions. The operation optimization AI inputs a large amount of preprocessed data into the surrogate model and searches for a value of input data such that a value of predetermined data among output data becomes an optimal value, according to a predetermined optimization algorithm. Since the surrogate model can instantly calculate output data from input data, it is possible to search for an optimal solution from a vast combination of input data by using the surrogate model even in a complex process where a simulation calculation takes several days to several weeks.

The flow of the work process as described above is similar when developing an operation optimization AI for another plant facility. Therefore, when information on the work process from when a model was developed is accumulated, when developing a similar type of model next time, the model can be smoothly developed in a similar work process by referring to past results. This can facilitate the formulation of a work plan and the management of a work process for developing the model, thereby reducing the cost, time, labor, etc., for the development of the model.

Some of the work processes included in the development of the operation optimization AI are also executed in the development of an operation optimization AI for another plant facility or another model. For example, considering the characteristic that operation data is time-series data collected during the operation of a plant facility, and it is generally expected that values are continuous and it is difficult to assume that they will suddenly change to completely different values without context, the task of removing data that has increased or decreased by a predetermined rate of change or more from the immediately preceding value as an outlier, as a task for preprocessing the operation data, is a task that should be commonly executed also in the development of an operation optimization AI for another plant facility or another model. When such a common task is packaged in advance, an existing package can be used when newly developing a model, so that the cost, time, labor, etc., required for the development of the model can be significantly reduced.

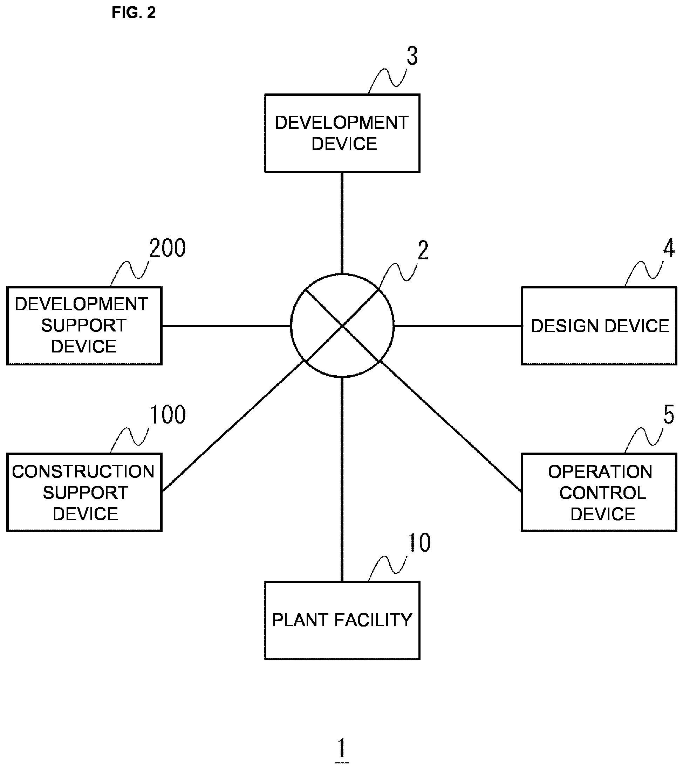

FIG. 2 illustrates a configuration of a development support system according to an embodiment. A development support system 1 comprises a development device 3, a design device 4, an operation control device 5, a construction support device 100, a development support device 200, and a communication network 2 for communicably connecting them.

A plant facility 10 includes facilities, equipment, devices, piping, and the like for executing a process in a plant. For example, in a chemical plant, the plant facility 10 includes a reactor, a separation device, a drying device, piping, and the like.

The development device 3 develops a model related to the operation of the plant facility 10. The model may be a simulation model that simulates an operation state of the plant facility 10, a state of a fluid, etc., a reaction model that simulates a chemical reaction in the plant facility 10, a surrogate model that substitutes for the simulation model, the reaction model, etc., an AI for verifying scale-up or scale-down in the design of the plant facility 10, an AI for optimizing the operation of the plant facility 10, an AI for detecting or predicting an abnormality during the operation of the plant facility 10, or the like.

The design device 4 designs the plant facility 10 using the model developed by the development device 3.

The operation control device 5 controls the operation of the plant facility 10 using the model developed by the development device 3.

The development support device 200 supports the development of the model in the development device 3. The development support device 200 acquires facility identification information of the plant facility 10 or process identification information of a process executed in the plant facility 10, and target output information of the model, and outputs a processing element list including a processing element that is to constitute a development process of the model, based on the acquired facility identification information or process identification information and the target output information. This allows a developer to develop a model using a processing element list of a model developed in the past, thereby significantly reducing the cost, time, labor, etc., for development.

The target output information of the model is information that the model finally or intermediately outputs according to a purpose of the model. For example, the target output information of the simulation model is a simulation result, and the target output information of the operation optimization AI is an operation parameter for optimizing the operation of the plant facility 10.

The construction support device 100 accumulates past result information to be referred to by the development support device 200 when outputting the processing element list, and supports the construction of a development support environment. The construction support device 100 acquires facility identification information of the plant facility 10 or process identification information of a process executed in the plant facility 10, which is a target of a developed model, and target output information of the developed model, acquires a processing element that constitutes a development process of the developed model, and stores the processing element in association with the facility identification information or the process identification information, and/or the target output information.

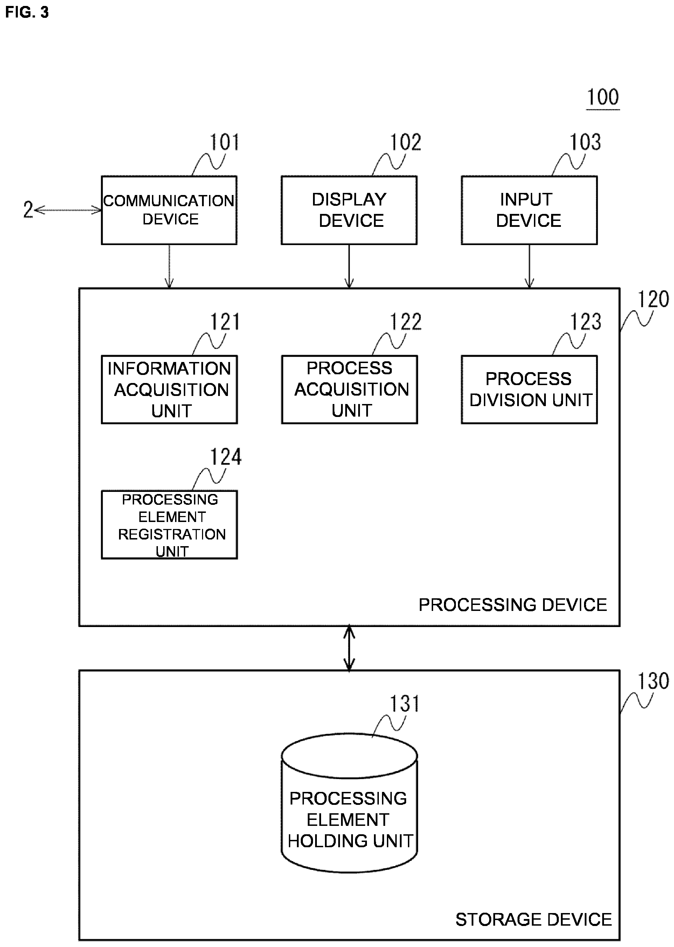

FIG. 3 illustrates a configuration of the construction support device 100 according to the embodiment. The construction support device 100 comprises a communication device 101, a display device 102, an input device 103, a processing device 120, and a storage device 130.

The communication device 101 controls wireless or wired communication. The display device 102 displays a screen generated by the processing device 120. The display device 102 may be a liquid crystal display device, an organic EL display device, or the like. The input device 103 transmits an instruction input by a user of the construction support device 100 to the processing device 120. The input device 103 may be a mouse, a keyboard, a touchpad, or the like. The display device 102 and the input device 103 may be implemented as a touch panel.

The storage device 130 stores data and a computer program used by the processing device 120. The storage device 130 comprises a processing element holding unit 131.

The processing element holding unit 131 holds a processing element that is to constitute a development process of a model related to the operation of the plant facility 10, in association with facility identification information or process identification information of the plant facility 10, and/or target output information of the model. The processing element holding unit 131 may hold a source code of a module that is to constitute the development process of the model, or the model itself. Furthermore, the processing element holding unit 131 may hold a variable, a constant, a parameter, and the like included in the source code.

The processing device 120 comprises an information acquisition unit 121, a process acquisition unit 122, a process division unit 123, and a processing element registration unit 124. These configurations are realized by, in terms of hardware components, an arbitrary circuit, a CPU of a computer, a memory, a program loaded into the memory, and the like, but here, functional blocks realized by their cooperation are depicted. Therefore, it is understood by those skilled in the art that these functional blocks can be realized in various forms by hardware only, software only, or a combination thereof.

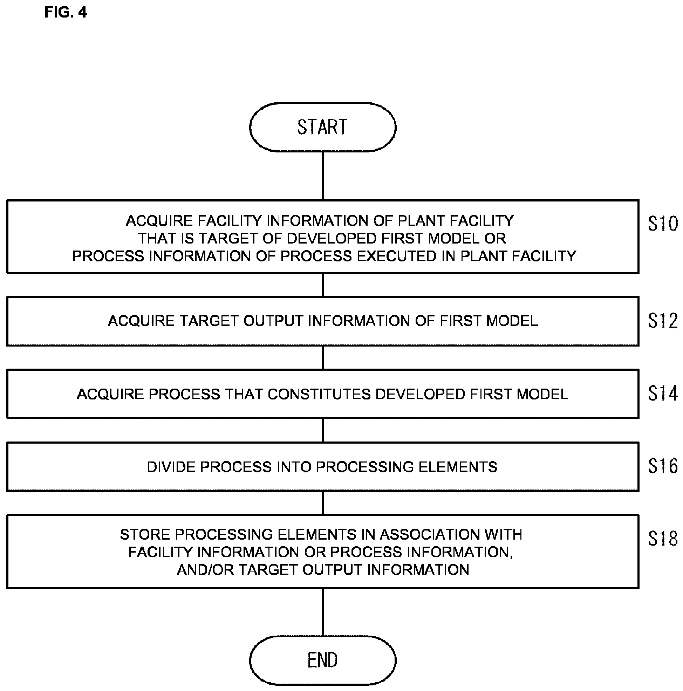

FIG. 4 is a flowchart illustrating a procedure of a support method according to the embodiment. With reference to FIG. 3 and FIG. 4, a procedure for supporting the construction of a development support environment by the construction support device 100 will be described. Note that a developed model is referred to as a "first model," and a newly developed model is referred to as a "second model."

The information acquisition unit 121 acquires facility identification information of a plant facility that is a target of the developed first model, or process identification information of a process executed in the plant facility (S10). The facility identification information may include information such as a type, a scale, a size, and performance of the plant facility. The process identification information may include information such as a raw material, a final product, an intermediate product, a type of reaction or processing, a time, and a condition. The information acquisition unit 121 may acquire the facility identification information or the process identification information from the development device 3, the design device 4, the development support device 200, or the like. The information acquisition unit 121 may acquire the facility identification information or the process identification information from a developer or the like via the input device 103.

The information acquisition unit 121 acquires target output information of the developed first model (S12). The target output information is information that the model finally or intermediately outputs, and includes, for example, a condition such as a value of a control amount for optimizing the operation of the plant in the above-described plant optimization model. The information acquisition unit 121 may acquire the target output information from the development device 3, the design device 4, the development support device 200, or the like. The information acquisition unit 121 may acquire the target output information from a developer or the like via the input device 103. The information acquisition unit 121 may acquire the target output information by analyzing a source code, a system design drawing, or the like of the first model.

The process acquisition unit 122 acquires a process that constitutes the developed first model (S14). The process may include a work process for developing the first model, a component (module) constituting the first model, or the like. The process acquisition unit 122 may acquire a source code, a variable, a constant, a parameter, and the like of a module constituting the first model. The process acquisition unit 122 may acquire the process from the development device 3, the design device 4, the development support device 200, or the like. The process acquisition unit 122 may acquire the process from a developer or the like via the input device 103.

The process division unit 123 divides the acquired process into a plurality of processing elements as necessary, such as when the process acquisition unit 122 has acquired the entire first model (S16). The process division unit 123 may divide the process in units of work processes. The process division unit 123 may divide the process into a processing element that is common in the development of a plurality of models and a processing element that is individually different depending on the type of the plant, the target output information of the model, and the like. Note that when the process acquisition unit 122 can acquire the process of the first model for each processing element, the division of the process by the process division unit 123 may not be performed.

The processing element registration unit 124 stores the processing element in the processing element holding unit 131 in association with the facility identification information or the process identification information, and/or the target output information.

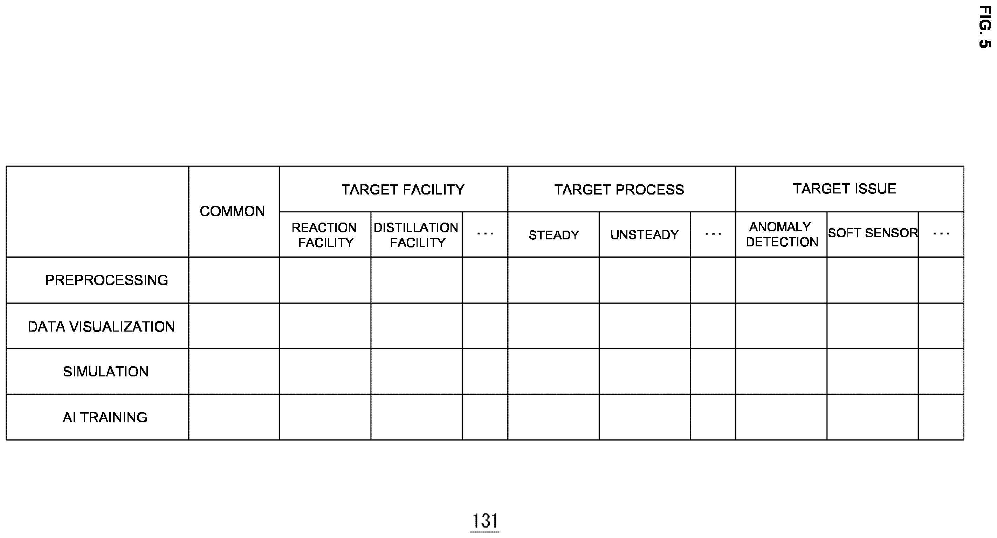

FIG. 5 illustrates an example of a data structure of the processing element holding unit 131. In the example of this figure, a processing element is held for each target plant facility, process, and issue (target output information). In addition, a processing element that is commonly included in a model regardless of the target plant facility, process, and issue is held.

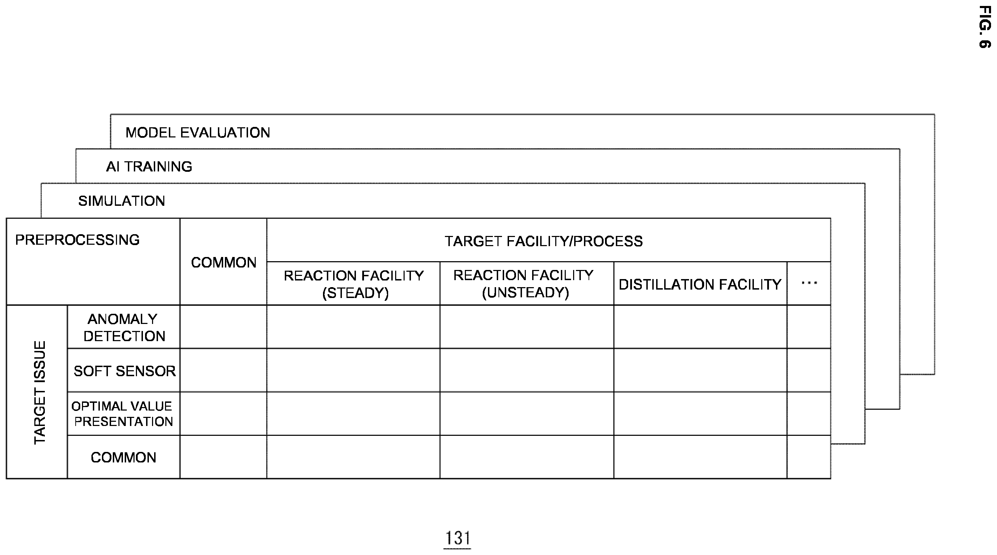

FIG. 6 illustrates an example of a data structure of the processing element holding unit 131. In the example of this figure, a processing element holding unit 131 is provided for each work process. In the processing element holding unit 131 of each work process, a processing element is held in a matrix of a target plant facility and process, and a target issue (target output information). Note that the processing element holding unit 131 is not limited to a relational database as shown in FIGS. 5 and 6, but may be configured as, for example, a graph database in which each processing element is linked by an edge to a target plant facility and process, and/or a target issue.

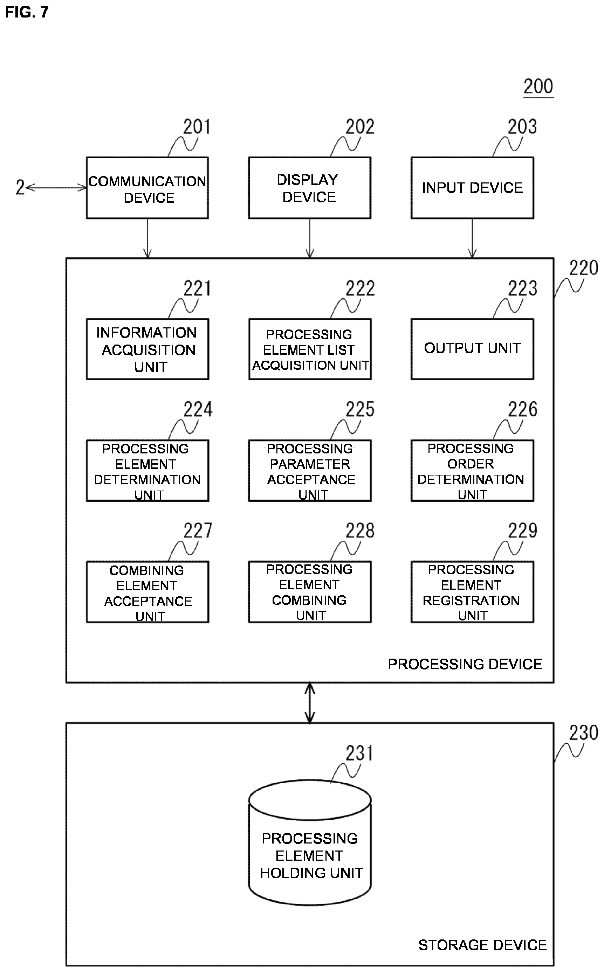

FIG. 7 illustrates a configuration of the development support device 200 according to the embodiment. The development support device 200 comprises a communication device 201, a display device 202, an input device 203, a processing device 220, and a storage device 230.

The communication device 201 controls wireless or wired communication. The display device 202 displays a screen generated by the processing device 220. The display device 202 may be a liquid crystal display device, an organic EL display device, or the like. The input device 203 transmits an instruction input by a user of the development support device 200 to the processing device 220. The input device 203 may be a mouse, a keyboard, a touchpad, or the like. The display device 202 and the input device 203 may be implemented as a touch panel.

The storage device 230 stores data and a computer program used by the processing device 220. The storage device 230 comprises a processing element holding unit 231.

The processing element holding unit 231 holds a processing element that is to constitute a development process of a model related to the operation of the plant facility 10, in association with facility identification information or process identification information of the plant facility 10, and/or target output information of the model. The processing element holding unit 231 may be the same as the processing element holding unit 131. The processing element holding unit 231 may be acquired from the construction support device 100 and stored in the storage device 230. When the development support device 200 accesses the processing element holding unit 131 of the construction support device 100, the processing element holding unit 231 may not be provided.

The processing device 220 comprises an information acquisition unit 221, a processing element list acquisition unit 222, an output unit 223, a processing element determination unit 224, a processing parameter acceptance unit 225, a processing order determination unit 226, a combining element acceptance unit 227, a processing element combining unit 228, and a processing element registration unit 229. These configurations are realized by, in terms of hardware components, an arbitrary circuit, a CPU of a computer, a memory, a program loaded into the memory, and the like, but here, functional blocks realized by their cooperation are depicted. Therefore, it is understood by those skilled in the art that these functional blocks can be realized in various forms by hardware only, software only, or a combination thereof.

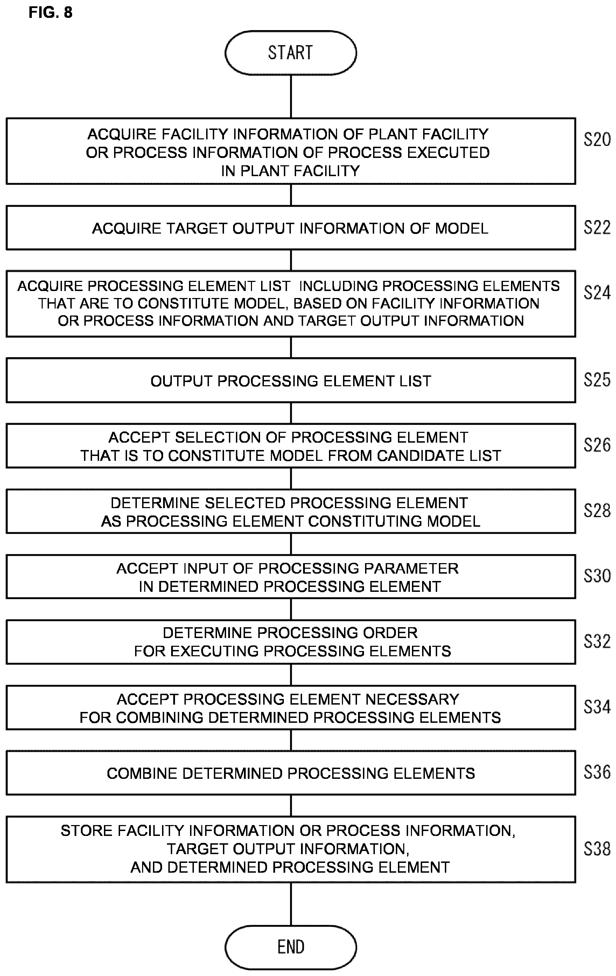

FIG. 8 is a flowchart illustrating a procedure of a support method according to the embodiment. With reference to FIG. 7 and FIG. 8, a procedure for supporting the development of a model by the development support device 200 will be described.

The information acquisition unit 221 acquires facility identification information of a plant facility to be developed or process identification information of a process executed in the plant facility (S20). The information acquisition unit 221 may acquire the facility identification information or the process identification information from the development device 3, the design device 4, or the like. The information acquisition unit 221 may acquire the facility identification information or the process identification information from a developer or the like via the input device 203.

The information acquisition unit 221 acquires target output information of the model (S22). The information acquisition unit 221 may acquire the target output information from the development device 3, the design device 4, or the like. The information acquisition unit 221 may acquire the target output information from a developer or the like via the input device 203.

The processing element list acquisition unit 222 acquires a processing element list including a processing element that is to constitute a development process of the model, based on the facility identification information or the process identification information and the target output information (S24). The processing element list acquisition unit 222 may acquire the processing element list with reference to the processing element holding unit 231 or the processing element holding unit 131. When the processing element holding unit 231 or the processing element holding unit 131 has the data structure illustrated in FIG. 5, the processing element list acquisition unit 222 extracts a processing element in which a target facility, a target process, and a target issue match the facility identification information, the process identification information, and the target output information, respectively, and a common processing element, to acquire a processing element list. When the processing element holding unit 231 or the processing element holding unit 131 has the data structure illustrated in FIG. 6, the processing element list acquisition unit 222 extracts, for each work process, a processing element in which a target facility, a target process, and a target issue match the facility identification information, the process identification information, and the target output information, respectively, and a common processing element, to acquire a processing element list.

The output unit 223 outputs the acquired processing element list to a developer as a candidate list of processing elements that are to constitute the development process of the model (S25). The output unit 223 may display the candidate list on the display device 202. The output unit 223 may transmit the candidate list to a terminal device used by the developer.

The processing element determination unit 224 accepts a selection of a processing element that is to constitute the development process of the model from the candidate list (S26), and determines the selected processing element as a processing element constituting the development process of the model (S28). The processing element determination unit 224 may accept a selection of a processing element from a developer via the input device 203. The processing element determination unit 224 may accept a selection of a processing element from a terminal device used by the developer. The processing element determination unit 224 may automatically determine a processing element listed in the processing element list as a processing element constituting the development process of the model. The processing element determination unit 224 may automatically select a processing element based on a predetermined selection criterion and determine the selected processing element as a processing element constituting the development process of the model. When a processing element is automatically selected, the selection of the processing element may be performed by a machine learning model. In that case, the machine learning model may be a model that learns a relationship between facility identification information and/or process identification information of an AI constructed in the past, target output information, and a processing element included in a development process of the AI, or a general AI construction flow not limited to a plant field, and determines a processing element of a second model by inputting facility identification information, process identification information, or target output information of the second model.

The processing parameter acceptance unit 225 accepts an input of a processing parameter in the determined processing element (S30). The processing parameter may include a parameter used when executing the processing element. The processing parameter acceptance unit 225 sets the accepted processing parameter in the processing element. The processing parameter acceptance unit 225 may accept a processing parameter from a developer via the input device 203. The processing parameter acceptance unit 225 may accept a processing parameter from a terminal device used by the developer. For example, when the processing element relates to an outlier removal process in preprocessing of operation data, an input of a parameter serving as a criterion for removing an outlier is accepted. The parameter that serves as the criterion for removing outliers may be based on the interquartile range (IQR) of the acquired data. For example:
The lower bound may be calculated as: (First Quartile) - 1.5×IQR
The upper bound may be calculated as: (Third Quartile) + 1.5×IQR

Note that the processing parameter may be set without requiring an input by a developer. In that case, an initial setting parameter such as a setting parameter in the first model may be stored in the processing element. In this case, the initial setting parameter may also be configured to be reviewed and edited by the developer as necessary.

The processing order determination unit 226 determines a processing order for executing the processing elements (S32). The processing order determination unit 226 may accept a processing order from a developer via the input device 203. The processing order determination unit 226 may accept a processing order from a terminal device used by the developer. The processing order determination unit 226 may automatically determine a processing order based on a predetermined criterion. The predetermined criterion may be, for example, a processing order in the first model, a criterion based on a processing order in an AI related to operation of a plurality of plants constructed in the past, such as the first model, or a criterion based on an order in AI development in other fields, not limited to plant operation. Such a criterion for the processing order may be obtained by referencing those stored in the processing element holding unit 231, or may be learned based on a processing order of an AI constructed in the past.

The combining element acceptance unit 227 accepts a processing element necessary for combining the determined processing elements (S34). When information output from a preceding processing element does not match information to be input to a succeeding processing element, a processing element that generates input information for the succeeding processing element from output information of the preceding processing element may be added as a combining element. The combining element acceptance unit 227 may accept a source code, a parameter, etc., of a combining element from a developer via the input device 203. The combining element acceptance unit 227 may accept a source code, a parameter, etc., of a combining element from a terminal device used by the developer. The combining element acceptance unit 227 may automatically generate a combining element based on output information of a preceding processing element and input information of a succeeding processing element.

The processing element combining unit 228 combines the determined processing elements (S36). The processing element combining unit 228 combines the determined processing element and the combining element in the determined processing order. Thereby, the second model is generated.

The processing element registration unit 229 stores the facility identification information or the process identification information, the target output information, and the determined processing element in the processing element holding unit 231 (S38). Thereby, a processing element constituting a development process of the developed model can be used for development of a model to be developed next time and thereafter.

When a developed model is changed or added, the contents of the processing element holding unit 131 and the processing element holding unit 231 may be updated accordingly.

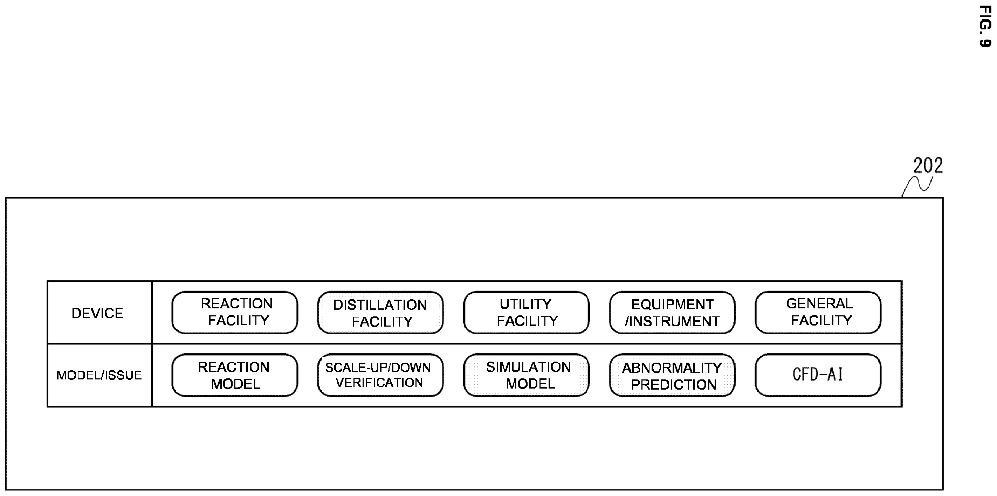

FIG. 9 illustrates an example of a screen displayed on the display device 202 of the development support device 200. In this figure, a user interface screen is displayed for a developer to select a type of device to be developed and a type of model or issue. When the developer selects the type of device and the type of model or issue, the information acquisition unit 221 acquires facility identification information of the plant facility to be developed and target output information of the model.

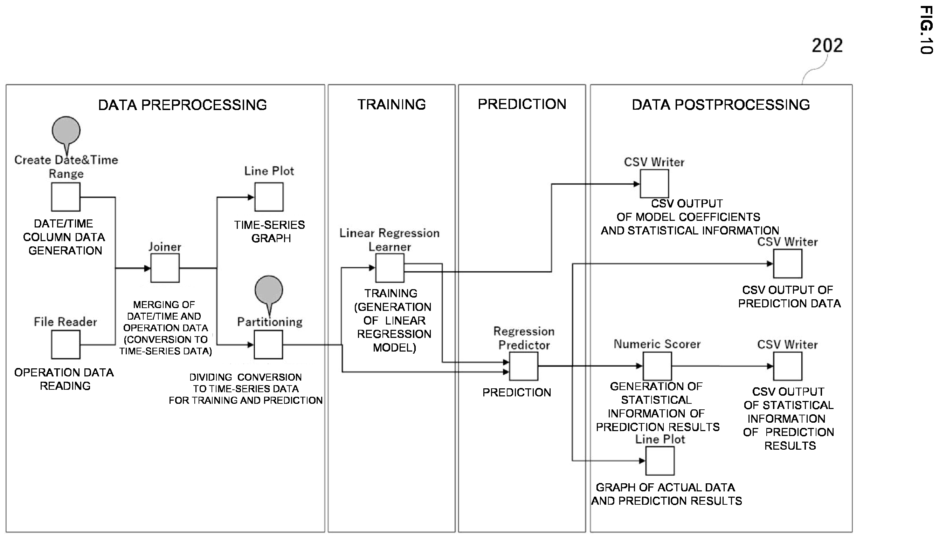

FIG. 10 illustrates an example of a screen displayed on the display device 202 of the development support device 200. In this figure, a list of processing elements that are to constitute a development process of a model, acquired by the processing element list acquisition unit 222 in accordance with the type of device and the type of model or issue selected by the developer, is displayed by the output unit 223.

Next, an example of a processing element held in the processing element holding unit 131 and/or the processing element holding unit 231 will be described.

### 1. Common Processing Element

In an embodiment, the common processing element comprises a plant design information acquisition element, an acquired data tag identification element, a data acquisition period identification element, an operation data acquisition element, an operation data time-series visualization element, an operation data processing/visualization element, an operation data sufficiency check element, and an operation data storage element.

The plant design information acquisition element is a processing element that acquires design information related to facility identification information or process identification information input as a plant facility that is the subject of the model to be developed. The plant design information acquisition element is, for example, a module that executes a process of acquiring a process flow diagram, a P&ID diagram, a data sheet of each piece of equipment, and the like of a plant that is the subject of a development model.

The acquired data tag identification element is an element that identifies a data tag (equipment constituting a plant and a parameter related to the equipment) necessary for developing a target model from information included in plant design information acquired by the plant design information acquisition element. The acquired data tag identification element may be, for example, a module configured by: a process of identifying equipment on a P&ID of a target plant of a model to be developed this time and inlet conditions and outlet conditions (substance, temperature, pressure, flow rate) of each piece of equipment; a process of acquiring target equipment and parameters of operation data used in development of a previously developed similar model; and a process of collating the target equipment and parameters acquired for the previously developed model with the equipment and the inlet conditions and the outlet conditions of the target plant of the model to be developed this time, to identify a data tag to be acquired.

The data acquisition period identification element is a processing element that identifies a period for acquiring plant operation data corresponding to a data tag to be acquired, which is identified by the acquired data tag identification element. The data acquisition period identification element is, for example, a module that sets a period for ensuring the accuracy of a model to be constructed this time, based on a period of operation data used for construction in a model constructed in the past.

The operation data acquisition element is a processing element that executes acquisition of plant operation data corresponding to a data tag identified by the acquired data tag identification element over a period identified by the data acquisition period identification element. The operation data acquisition element may further execute a process of extracting a data range necessary for AI model construction from the acquired operation data. In this case, for example, a data region where a numerical value of pressure, flow rate, or liquid level is zero, or a range excluding data at the time of starting or switching the operation of the plant may be extracted.

The operation data time-series visualization element is a processing element that visualizes the acquired operation data in time series. The operation data time-series visualization element is, for example, a module that executes a process of displaying each piece of acquired operation data arranged in time series, a process of displaying the operation data in a histogram, a process of displaying a correlation between each piece of operation data, or a process of displaying an average value/a maximum value/a minimum value of each piece of operation data.

The operation data processing/visualization element is a processing element that calculates a parameter not directly measured in a plant based on the acquired operation data and visualizes the parameter. The operation data processing/visualization element is, for example, a processing element that executes a process of calculating a reaction rate from temperature data and concentration data acquired as operation data and displaying the calculated reaction rate in time series. In addition, the operation data processing/visualization element may execute a process of dividing the acquired operation data by a flow rate, and visualize the result in the form of a value per unit flow rate (for example, a heat input amount per unit flow rate).

The operation data sufficiency check element is a processing element that collates a data tag identified by the acquired data tag identification element and an acquisition period identified by the data acquisition period identification element with acquired operation data, and determines whether a type and a period of necessary operation data are satisfied. The operation data sufficiency check element is, for example, a module that executes a process of collating the identified data tag with the acquired operation data, and a process of collating the identified period with the acquired operation data, and when there is a type or a period of operation data with excess or deficiency, executes a process of displaying the type or the period of the data.

The operation data storage element is a processing element that executes a process of storing the acquired operation data in a storage unit.

The processing element holding unit 131 and/or the processing element holding unit 231 further comprise the following processing elements for each piece of target output information.

### 2. Processing Elements for Steady-State Fluid Simulation

As processing elements for constructing a model whose target output information is a steady-state fluid simulation by AI, a stable operation region extraction element, a simulation input data determination element, a simulation convergence element, an AI training data generation element, and a training execution element are provided.

The stable operation region extraction element is a processing element that extracts a region of stable operation from the operation data stored in the storage unit. The stable operation region extraction element is, for example, a module that defines a criterion such as a predetermined upper limit value or lower limit value, or a predetermined rate of change for each piece of operation data to be extracted, and executes a process of extracting operation data that satisfies this criterion.

The simulation input data determination element is a processing element that determines data to be input to a simulation when constructing a steady-state fluid simulation. The simulation input data determination element is, for example, a module that determines a parameter (temperature, pressure, composition, etc.) and a data point (inlet, outlet, specific location inside equipment, etc.) that affect a fluid state represented in the simulation, and executes a process of determining corresponding operation data as input data.

The simulation execution element is a processing element that executes a simulation with input data determined by the simulation input data determination element. The simulation execution element may execute a process of acquiring an existing simulator, or may execute a process of constructing a new simulator. The simulation execution element may also execute a process of adjusting a parameter in the simulation so that a simulation result converges within a certain range while executing the simulation.

The AI training data generation element is a processing element that prepares a data set of input data determined by the simulation input data determination element and a corresponding simulation result, and generates data for training an AI. In addition, a range of training data and a distribution of data suitable for further improving the accuracy of the AI may be set in the AI training data generation element, and training data of the set range and distribution may be generated.

The training execution element is a processing element that executes a training process of an AI using the training data generated by the AI training data generation element. The training execution element is, for example, a module in which a training algorithm is defined.

### 3. Processing Elements for Anomaly Detection

As processing elements for constructing an anomaly detection model for plant operation by AI, the processing element holding unit comprises a data classification element, a data preprocessing element, a training data generation element, a training execution element, and an AI verification element.

The data classification element is a processing element that classifies, from among the operation data stored in the storage unit, data corresponding to an abnormal operation and data corresponding to a normal operation. The data classification element is, for example, a module that acquires a time when an abnormality occurred in the operation of a plant, identifies each piece of operation data corresponding thereto, identifies a characteristic (a value, a rate of change of the value, etc.) of the operation data at the time of the abnormality, and classifies the data at the time of the abnormality from among time-series operation data.

The data preprocessing element is a processing element that processes data such that operation data at the time of an abnormality and operation data at the time of normal operation can be distinguished. The data preprocessing element is, for example, a module that executes a process of adding operation data at the time of an abnormality and at the time of normal operation, respectively.

The training data generation element is a processing element that generates training data for training an AI. The training data generation element is, for example, a module that prepares operation data labeled as to whether it is data at the time of an abnormality. Note that scenes in which an abnormality occurs in the operation of a plant are limited, and abundant operation data at the time of an abnormality may not be acquired. Therefore, when operation data at the time of an abnormality for training is limited, the training data generation element may execute a process of generating operation data at the time of an abnormality by simulation and adding it as training data.

The training execution element is a processing element that executes the training of an AI using the training data generated by the training data generation element. The training execution element is, for example, a module in which a training algorithm is defined.

The AI verification element is a processing element that verifies whether an AI trained by the training execution element can correctly determine an operation abnormality. The AI verification element is, for example, a module that acquires operation data for a period different from the operation data used for training the AI, and information indicating whether the operation data is from a time of an abnormality, and executes a process of verifying whether the presence or absence of an abnormality can be correctly determined by inputting the operation data for that period into the constructed AI. In addition, the AI verification element may include a process of defining a reference threshold value (for example, the number of times an abnormal value is detected within a predetermined time) for identifying an occurrence of an abnormality. The reference threshold value may be selected or modified from a past definition.

### 4. Processing Elements for Reaction Model

As processing elements for constructing a model whose target output information is a reaction model by AI, a predicted data range determination element, an operation data preprocessing element, a reaction analysis element, a training data generation element, and a training execution element are provided.

The predicted data range determination element is a processing element that determines a range of data to be predicted by a reaction model by an AI. The predicted data range determination element is, for example, a module that executes a process of determining a data range to be predicted by a reaction model to be constructed, based on the progress of a reaction (a reaction rate, a catalyst activity, etc.) that can occur in a plant operation.

The operation data preprocessing element is a processing element that acquires operation data from a storage unit and performs necessary preprocessing for constructing a reaction model.

The reaction analysis element is a processing element that analyzes one or more reaction paths that can occur in a target plant facility or process, an occurrence ratio of each reaction, and the like. The reaction analysis element may be, for example, a module in which a reaction path and an occurrence ratio are set in advance for each plant facility or each process, or may be a module that acquires plant design information and operation data, and analyzes and identifies the reaction path and the occurrence ratio based on the acquired data.

The training data generation element is a processing element that generates training data for training an AI reaction model. The training data generation element is, for example, a module that executes a process of generating data in association with operation data preprocessed by the operation data preprocessing element and each reaction path and its occurrence ratio analyzed by the reaction analysis element.

The training execution element is a processing element that executes the training of an AI using the training data generated by the training data generation element. The training execution element is, for example, a module in which a training algorithm is defined.

The processing elements described above can be held as common elements or as processing elements specialized for each piece of target output information. In model development using the development support device 200, all such processing elements may be used, or some of them may be created by a developer. A developer can quickly and easily execute model development by combining such pre-prepared processing elements.

According to the development support system of the present embodiment, since knowledge and resources from when a model was developed in the past are used, the development of a model, which has conventionally been performed individually, can be made more efficient, and the cost, time, labor, etc., required for the development of a new model can be significantly reduced. In addition, since it is possible to divide the labor of model development, a process engineer, a data scientist, an AI developer, and the like can concentrate on their respective essential tasks.

The present invention has been described above based on an embodiment. This embodiment is an exemplification, and it is understood by those skilled in the art that various modifications can be made to combinations of the respective constituent elements and respective processing processes, and that such modifications are also within the scope of the present invention.

In the embodiment, an example has been described in which a processing element constituting a model developed in the past is held in the processing element holding unit 131 in advance. In another example, when the processing element list acquisition unit 222 acquires a list of processing elements, information regarding a model developed in the past may be collected. Also in this case, the processing element holding unit 131 may be temporarily generated.

### Reference Signs List

1 development support system, 2 communication network, 3 development device, 4 design device, 5 operation control device, 10 plant facility, 100 construction support device, 101 communication device, 102 display device, 103 input device, 120 processing device, 121 information acquisition unit, 122 process acquisition unit, 123 process division unit, 124 processing element registration unit, 130 storage device, 131 processing element holding unit, 200 development support device, 201 communication device, 202 display device, 203 input device, 220 processing device, 221 information acquisition unit, 222 processing element list acquisition unit, 223 output unit, 224 processing element determination unit, 225 processing parameter acceptance unit, 226 processing order determination unit, 227 combining element acceptance unit, 228 processing element combining unit, 229 processing element registration unit, 230 storage device, 231 processing element holding unit

### Industrial Applicability

The present invention can be used for a support device that supports the development of a model related to the operation of a plant facility.

## Claims

1. A method for supporting development of a model related to operation of a plant facility, the method being executed by a processor, the method comprising:
acquiring facility identification information of the plant facility or process identification information of a process executed in the plant facility;
acquiring target output information of the model; and
outputting a processing element list including a processing element that is to constitute a development process of the model, based on the facility identification information or the process identification information and the target output information.

2. The method according to Claim 1, wherein
the processing element list is a candidate list of processing elements that are to constitute the development process of the model.

3. The method according to Claim 2, wherein
the processor further executes:
accepting a selection of a processing element that is to constitute the development process of the model from the candidate list; and
determining the selected processing element as a processing element constituting the development process of the model.

4. The method according to Claim 1, wherein
the processing element list is determined by the processor as a processing element constituting the development process of the model.

5. The method according to Claim 3 or 4, wherein
the processor accepts an input of a processing parameter in the determined processing element.

6. The method according to Claim 1, wherein
the processor further executes determining a processing order for executing the processing elements.

7. The method according to Claim 1, wherein
the processing element includes a source code or a model related to a corresponding process.

8. The method according to Claim 3 or 4, wherein
the processor further executes storing the facility identification information or the process identification information, the target output information, and the determined processing element.

9. The method according to Claim 3 or 4, wherein
the processor further executes combining the determined processing elements.

10. The method according to Claim 8, wherein
the processor further executes accepting a processing element necessary for combining the determined processing elements.

11. The method according to Claim 1, wherein
the processing element is an element configured by dividing a process that constitutes a development process of a previously created model.

12. A support device comprising:
an information acquisition unit that acquires facility identification information of a plant facility or process identification information of a process executed in the plant facility, and target output information of a model related to operation of the plant facility; and
an output unit that outputs a processing element list including a processing element that is to constitute a development process of the model, based on the facility identification information or the process identification information and the target output information acquired by the information acquisition unit.

13. A support program for causing a computer to function as:
an information acquisition unit that acquires facility identification information of a plant facility or process identification information of a process executed in the plant facility, and target output information of a model related to operation of the plant facility; and
an output unit that outputs a processing element list including a processing element that is to constitute a development process of the model, based on the facility identification information or the process identification information and the target output information acquired by the information acquisition unit.

14. A method for constructing a development support system for a second model related to operation of a plant facility, the method being executed by a processor, the method comprising:
acquiring facility identification information of the plant facility or process identification information of a process executed in the plant facility, which is a target of a developed first model, and target output information of the first model;
acquiring a processing element that constitutes a development process of the developed first model; and
storing the processing element in association with the facility identification information or the process identification information, and/or the target output information.

15. The method according to Claim 14, wherein
the processor creates the processing element by dividing a process that constitutes the development process of the first model.

16. A support device for constructing a development support system for a second model related to operation of a plant facility, the support device comprising:
an information acquisition unit that acquires facility identification information of the plant facility or process identification information of a process executed in the plant facility, which is a target of a developed first model, and target output information of the first model;
a processing element acquisition unit that acquires a processing element that constitutes a development process of the developed first model; and
a storage unit that stores the processing element in association with the facility identification information or the process identification information, and/or the target output information.

17. A support program for constructing a development support system for a second model related to operation of a plant facility,
the support program causing a computer to function as:
an information acquisition unit that acquires facility identification information of the plant facility or process identification information of a process executed in the plant facility, which is a target of a developed first model, and target output information of the first model;
a processing element acquisition unit that acquires a processing element that constitutes a development process of the developed first model; and
a storage unit that stores the processing element in association with the facility identification information or the process identification information, and/or the target output information.
